# EUROPEAN PATENT SPECIFICATION

(11) **EP 0 397 093 B1**
(45) Date of publication and mention of the grant of the patent: **13.03.1996**
(21) Application number: 90108601.7
(22) Date of filing: 07.05.1990
(51) Int. Cl.: H04Q 3/52, H03K 17/693

(54) **Broadband space switch using path sensitizing**
Breitbandraumkoppelfeld mit Gebrauch von Vermittlungswegsensibilisierung
Matrice de commutation spatiale à large bande utilisant une sensibilisation des parcours

(30) Priority: 09.05.1989 US 351632
(43) Date of publication of application: 14.11.1990
(73) Proprietor: GTE LABORATORIES INCORPORATED, Wilmington Delaware 01901 (US)
(72) Inventor: Cooperman, Michael, Framingham, MA 01701 (US); Sieber, Richard W., Attleboro, MA 02703 (US); Paige, Arnold, Natick, MA 01760 (US)
(74) Representative: Grünecker, Kinkeldey, Stockmair & Schwanhäusser Anwaltssozietät

(56) References cited:
- US-A- 3 614 327
- PATENT ABSTRACTS OF JAPAN vol. 10, no. 233 (E-427)(2289) 13 August 1986, & JP-A- 61 65623 (NIPPON TELEGR. & TELEPH. CORP.) 4 April 1986,
- PATENT ABSTRACTS OF JAPAN vol. 10, no. 50 (E-384)(2107) 27 February 1986, & JP-A-60 201795 (NIPPON DENSHIN DENWA KOSHA) 12 October 1985,
- IBM TECHNICAL DISCLOSURE BULLETIN. vol. 28, no. 3, August 1985, NEW YORK US pages 1302 - 1303; "CMOS Self-decoding Complementary Pass Gate Multiplexer"
- ELECTRONICS. vol. 56, no. 19, September 1983, NEW YORK US pages 144 - 148; S. Whitaker: "Pass-transistor networks optimize n-MOS logic"
- N.H.E. Weste et al, "Principles of CMOS VLSI Design" 1985, Addison Wesley, Reading, US pages 172 - 203;
- IEEE JOURNAL OF SOLID-STATE CIRCUITS. vol. sc-22, no. 2, April 1987, NEW YORK US pages 216 - 222; J.H. Pasternak et al: "CMOS Differential Pass-Transistor Logic Design"
- Technical Digest, IEEE Gallium Arsenide Integrated Circuit Symposium, 13-18 Oct. 1987, pages 245-248, Portland US S. Hayano et al: "A GaAs 8x8 Matrix Switch LSI for High-Speed Digital Communications"
- Digest of Technical Papers, IEEE International Solid State Circuits Conf., 17-19 Feb. 1988, pages 116-117, San Francisco US F.E. Barber et al: "A 64x17 Non Blocking Crosspoint Switch"
- WIRELESS WORLD. vol. 84, no. 1507, March 1978, HAYWARDS HEATH GB pages 47 - 50; B. Holdsworth et al: "Logic Design"

## Description

This invention relates to broadband space switch matrices as defined in the preamble parts of patent claims 1 and 3.

There are current efforts in the telecommunications industry to provide broadband video services utilizing high performance technology at low cost. CMOS technology has the potential to provide broadband switching at low cost due to its high speed, high density, and low power dissipation.

The performance of broadband switches implemented in CMOS is affected by the specific configuration. In particular, a majority of conventional CMOS space switches encounter size and speed limitations due to stray capacitances in the array crosspoints. A relatively new switch architecture having a tree-switch configuration has been introduced recently that overcomes the aforecited limitations by isolating each crosspoint from the stray capacitances in the array. The configurations for implementing these tree-switches offer improvements in speed, chip area economy, and power dissipation. One such configuration is the 64 X 17 non-blocking crosspoint switch disclosed by Barber et al. in Digest of Technical Papers IEEE International Solid-State Circuits Conference, 17-19 Feb. 1988 pages 116-117.

The Barber, et al. switch is constructed as a series of cascaded stages wherein the first stage consists of NAND gates each receiving an input signal and the remaining stages are comprised of switching nodes having a NAND gate cascaded to an inverter. The control is relatively simple in that only the NAND gates in the first stage receive control signals to effect a desired propagation path. Since only the gates in the sensitized path are operable to be switched due to the control signals, low power dissipation is possible.

Disadvantageously, an input signal propagating through the Barber et al. switch experiences an undesirable delay due to the cascaded sequence of NAND gate and associated inverter in each stage of the switch. Furthermore, the input signal is susceptible to pulse narrowing since rising and falling inputs could be treated differently by the cascaded sequence of NAND gate and inverter.

Regarding pulse-width narrowing, it is impossible in Barber, et al. for the rise and fall delay to stay exactly the same with variations in process, supply voltage, and environmental tolerances. Consequently, an unequal rise and fall delay causes the bit element pulse to shrink or expand thereby reducing operating speed. For example, if every stage produced a pulse shrinkage of 0.2 ns, then the 13 cascaded stages in a 64 X 1 input switch would cause a pulse shrinkage of 13 X 0.2 = 2.6 ns. Thus, an input pulse of 7 ns (corresponding to 150 Mb information rate) would shrink at the output to 4.4 ns. This would prevent one 64 module from driving the next without reclocking the output and expanding the 4.4 ns pulses back to 7 ns. Constant pulse width is difficult to achieve since the gates in successive stages are not identical, resulting in inexact compensation of rise and fall delay.

The object underlying the present invention is to provide a switch matrix which is fast with respect to the propagation of the input signals and exact in operation.

This object is solved by a switch matrix having the features of claims 1 and 3.

Preferred embodiments are subject to various dependent claims.

The invention will be more fully understood from the following description of the preferred embodiment with reference to the figures.

In the drawings:
Figure 1 is a prior art circuit diagram of an 8 X 1 tree-switch matrix;
Figure 2 shows a pair of inverter circuits illustrating the effect of cascaded inversion on an input signal having both a rising and falling edge;
Figure 3 shows an 8 X 1 tree-switch matrix in accordance with one embodiment of the present invention; and
Figure 4 shows an 8 X 1 tree-switch matrix in accordance with a preferred embodiment of the present invention.

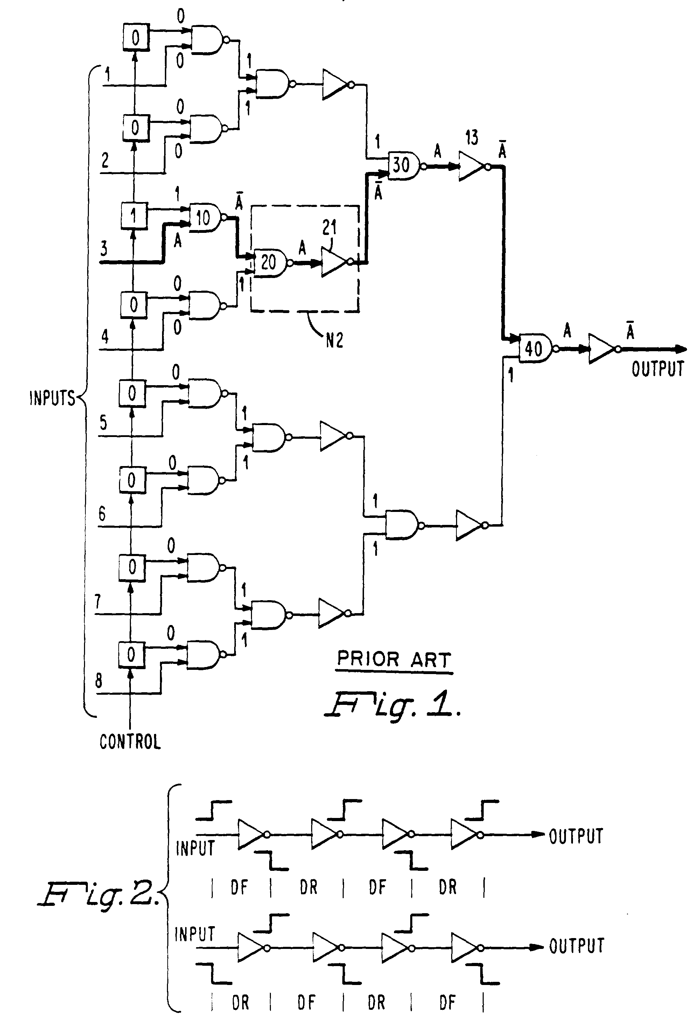

The prior art tree-switch matrix in Figure 1 is shown as an 8 X 1 switch for exemplary purposes. The four stages comprising the matrix operate in a cascaded tree configuration to accept eight input signals through the NAND gates in stage No. 1 and provide a selected one of the signals in accordance with the control signals applied to the NAND gates in stage No. 1. The bit pattern of control signals as shown in Figure 1 enable signal A entering input 3 to propagate through the switch. Each switching node N2 in the remaining stages after stage No. 1 includes a NAND gate 20 cascaded to an inverter 21. As mentioned hereinbefore, there cannot be exact compensation of rise and fall delay in the switching node N2 due to the different switching delays of NAND gate 20 and inverter 21.

When a digital signal propagates thorough a chain of identical inverting logic gates such as those shown in the circuit diagrams of Figure 2, the pulse width of the signal is unaffected even when the rise delay (DR) and the fall delay (DF) are not equal. This is due to the fact that the sums of DF's and DR's are the same for both rising inputs and for falling inputs. In contradistinction, the switching nodes in Fig. 1 cause pulse-width narrowing.

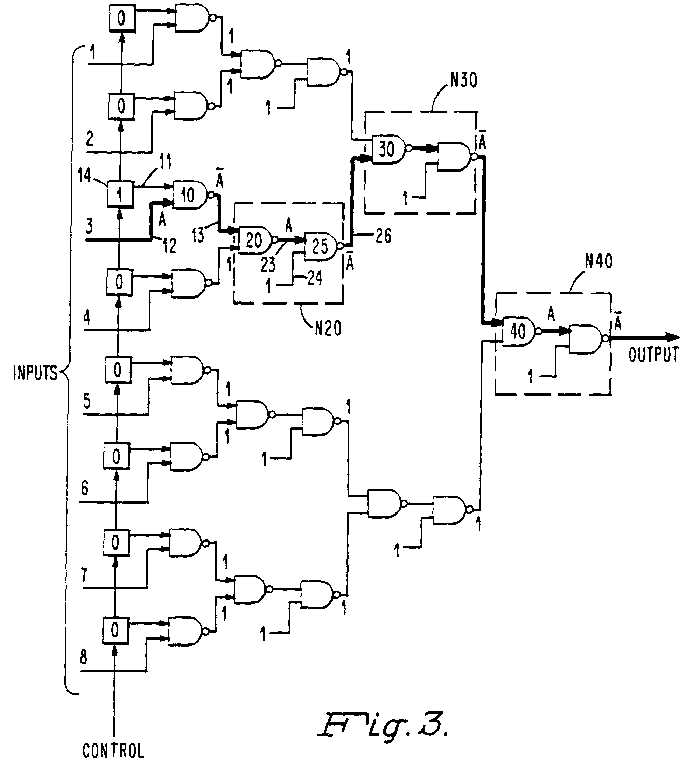

In one embodiment of the present invention as shown in Figure 3, the logic circuits of Figure 2 are incorporated into a novel tree-switch configuration having improvements to the prior art switch of Figure 1. The tree-switches of Fig. 1 and Fig. 3 are similar in construction and operation except that where each switching node N2 in Figure 1 includes a cascaded sequence of NAND gate 20 and inverter 21, a representative switching node N20 in Figure 3 includes a first NAND gate 20 cascaded to an identical second NAND gate 25. The advantage of replacing the inverter with a NAND gate is that the cascaded sequence of NAND gates avoids the problem of pulse-width narrowing present in Figure 1.

The array in Figure 3 has a plurality of stages configured as a tree matrix wherein stage No. 1 includes NAND gates each connected to an input port and the remaining stages consist of switching nodes which are constructed as described above. In stage No. 1, a representative NAND gate 10 has one input 12 connected to input port 3 and a second input 11 through which control signals such as signal 14 are coupled to gate 10. Each other NAND gate in stage No. 1 likewise has an input dedicated to receiving control signals. Switching node N20, being representative of the other switching nodes in the matrix, has the output of its first gate 20 connected to a first input 23 of the associated second gate 25 wherein output 26 of gate 25 drives a single input of a first NAND gate 30 in the following stage No. 3. As is the case in every switching node, a HIGH steady-state logic signal is present at a control input 24 of second gate 25 for ensuring that gate 25 is always operable to undergo switching.

The tree-switch in Fig. 3 operates in response to the control signals applied to the NAND gates in stage No. 1 to establish a desired switching path between one of the input ports and the output of switching node N40 in stage No.4. The selected path is established according to the appropriate set of control signals such that only the NAND gates in the selected path are operable to undergo switching, while the other NAND gates in the matrix are forced into steady-state logic levels. The particular control signals indicated in Figure 3 enable signal A to propagate through the switch while preventing unwanted signals entering the other input ports from proceeding past stage No. 1. Although a shift register is shown in Fig. 3 to indicate how the control signals are presented to the first stage of the switch, other means for applying control signals would be obvious to those skilled in the art.

A problem may exist in the tree-switch of Figure 3 when a switching node such as node N20 has its first gate 20 and the associated second gate 25 both part of the same switching node since this might result in the connection from gate 20 to gate 25 being shorter than the connection from gate 25 to gate 30 of switching node N30 in the following stage No. 3, thereby making the effective gates non-identical. This problem is avoided in the switch of Figure 3 by making the connection from gate 20 to gate 25 as long as that from gate 25 to gate 30. This requirement regarding connection lengths is likewise implemented in each other switching node of the tree-switch.

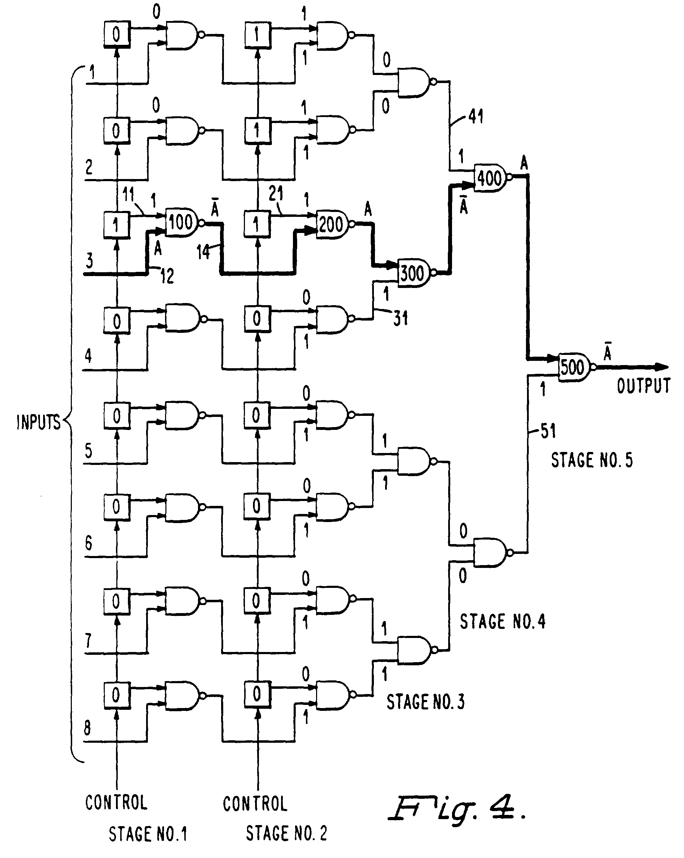

Figure 4 is a preferred embodiment of the tree-switch matrix in accordance with the present invention. Even though an 8 X 1 matrix is shown for exemplary purposes, the array can be easily expanded to include any number of inputs. In order to accommodate multiple outputs, such as in an MxN switch, the desired switch array is formed by driving N Mx1 switch arrays in parallel. Further expansion is possible by driving multiple MxN arrays in parallel.

The matrix operates to switch a digital signal entering of the input ports labeled 1-8 to the output port connected to the output of NAND gate 500 in stage No. 5. The tree-switch is constructed from a plurality of dual-input NAND gates wherein each NAND gate drives only a single NAND gate in a following stage. In the first two stages, each NAND gate receives external control signals at one of its inputs in order to establish a particular switching path in the matrix, whereas the NAND gates in the remaining stages have both of their inputs connected to different NAND gate outputs from a preceding stage and hence have not externally applied control signals other than the signals which are received from the prior stage.

The matrix in Figure 4 establishes a desired connection by sensitizing only the selected switching path. In other words, only the NAND gates in the selected path are operable to undergo switching, thereby permitting only the input signal entering the selected path to propagate through the switch. Any path can be sensitized by forcing the outputs of stage No. 1 and stage No. 2 to the appropriate states by applying a corresponding combination of control signals to the NAND gates in stages No. 1 and No. 2. The chart below shows the control inputs necessary to achieve a particular output from stage No. 2.

| Input to Stage 1 Gate | Control Input to Stage 1 Gate | Control Input to Stage 2 Gate | Output of Stage 2 Gate |
|---|---|---|---|
| A | HIGH | HIGH | A |
| A | HIGH OR LOW | LOW | HIGH |
| A | LOW | HIGH | LOW |

The appropriate control signals applied to stages No. 1 and No. 2 ensure that for each NAND gate in the selected path, the input line which is not carrying the selected signal is in a HIGH logic state. For example, the darkened switching path in Figure 4 corresponding to the switching path for signal A is established by maintaining a HIGH logic state level on the inputs 11, 21, 31, 41, and 51 of the gates 100, 200, 300, 400, and 500, respectively. When the switch is operating, the control signals indicated place HIGH state logic signals on select inputs 11 and 21 while forcing the outputs of each other NAND gate in the switch into a particular steady-state value such that inputs 31, 41, and 51 are placed in a HIGH state. The information provided in the chart above plus the output conditions of all stages necessary to establish any particular switching path are sufficient to determine the correspondingly appropriate combination of control signals to apply to stages No. 1 and No. 2. Although a shift register is shown in Fig. 4 to indicate how the control signals are presented to the first and second stage of the switch, other means for applying control signals would be obvious to those skilled in the art.

As mentioned hereinabove, the unique feature of the tree-switch in Figure 4 is that the only gates that switch and dissipate power are the gates in the sensitized path, namely gates 100, 200, 300, 400, and 500 for the path traversed by signal A. The remaining gates are either in a HIGH or LOW state in accordance with the control signals, thereby dissipating only standby power which is in the microwatt range for NAND gates implemented with CMOS technology. In this particular 8-input case, 5 out of a total of 23 gates are switched. For an array with 64 inputs, only 8 out of 191 gates would switch. In contradistinction, thirteen gates (including inverters) would be switched for a 64-input array configured like the switch in Figure 1. Clearly, the reduction in logic gates which a signal must traverse reduces the delay and power dissipation and thereby makes higher propagation speed possible.

What has been shown and described herein are two novel tree-switch matrices as shown in Figures 3 and 4 which have improvements to conventional broadband space switch matrices resembling the array of Figure 1. In one embodiment of the present invention as shown in Figure 3, each switching node N20 has a first NAND gate cascaded to a second NAND gate, whereas in the prior art switch of Figure 1 each switching node N2 has a NAND gate cascaded to an inverter. Advantageously, the cascade of NAND gates provides minimum pulse shrinkage. The preferred embodiment in Figure 4 and the prior art switch in Figure 1 both provide the following advantages: (1) low power dissipation because only the gates in the sensitized path are switched, and (2) high speed because each gate drives only one load. The Figure 4 switch, however, has the following advantages over the Figure 1 switch (1): approximately half the number of stages are in the switching path thereby providing less delay, higher throughput speed, and half the power dissipation, and (2) the total delay for positive and negative input transitions is the same even though the rise and fall delay of the NAND gates is not equal, thereby preventing pulse shrinkage and resulting in higher operational speed. Although the switch in Figure 1 has simplified control, this is not a critical performance parameter when fast control is not a requirement. Furthermore, the number of control lines is not a significant concern since the lines are only a small part of the chip real estate.

The architectures according to the present invention are not limited to CMOS implementation, and hence the means for establishing a desired switching path in accordance with the requirements described hereinabove accompanying the embodiments of Figs. 3 and 4 are applicable to other switch configurations which utilize different logic gates that are appropriate for the particular technology. For example, a tree-switch that is constructed from logic gates other than NAND gates might be a more advantageous design, but this embodiment still falls within the scope of the appended claims since a switching path is established in the same manner as set forth in the appended claims and the supporting specification. Because CMOS is the preferred technology for the switch array disclosed herein, the use of NAND gates is determined by the fact that the fastest gate in CMOS is the NAND gate.

The invention as defined by the claims provides a broadband space tree-switch matrix having high switching speed and very low power dissipation, and one that is immune to pulse-width narrowing.

## Claims

1. A switch matrix for receiving input digital signals through input ports (1-8) and providing a selected one of said signals as an output signal, comprising:
a first selection stage comprising a plurality of logic gates (100) each having a data input connected to a corresponding one of said input ports, a control input, and an output line;
a second selection stage cascaded to said first selection stage comprising a like plurality of logic gates (200) each having a data input connected to a single logic gate output line (14) from said first selection stage, a control input, and an output line;
a plurality of cascaded stages comprising logic gates (200, 300, 400) arranged into a multiplexing configuration for receiving logic signals and providing said selected signal;
each logic gate (300, 400, 500) in said plurality of cascaded stages having an output line, a first input connected to one of said logic gate outputs from a preceding stage, and a second input connected to a different one of said logic gate outputs from said preceding stage;
means for establishing a desired switching path in said plurality of cascaded stages by applying an appropriate combination of digital signals to the control inputs of said logic gates (100,200) in said first and second selection stage,
whereby only said logic gates in said chosen path are operable to undergo switching, thereby permitting only said selected input signal to propagate through said switch.

2. The matrix as recited in claim 1 wherein: said logic gates (100,200) in said first and second selection stages being NAND gates; and
said logic gates (300, 400, 500) in said multiplexing configuration being NAND gates.

3. A switch matrix for receiving input digital signals through input ports (1-8) and providing a selected one of said signals through an output port, comprising:
a plurality of cascaded stages wherein said first stage comprises a plurality of logic gates (10) and said remaining stages comprise a plurality of switching nodes (N20,N30,N40) each having a first input connection, a second input connection, an output connection, and a control input connection wherein each output connection drives a single input connection in a following stage;
each of said logic gates (10) having a data input connected to a corresponding one of said input ports (1-8), a control input, and an output line wherein each output line drives the input connection of a single switching node in a next stage;
said output port being coupled to the output connection of a single switching node (N40) in said last stage;
each of said switching nodes (N20,N30,N40) including a first logic gate (20, 30, 40) having a first data input connected to the first input connection of said respective switching node, a second data input connected to the second input connection of said respective switching node, and an output;
each of said switching nodes further includes a second logic gate (25) cascaded to said associated first logic gate (20) and having a data input connected to the output of said associated first logic gate, a control input (24) connected to the control input connection of said respective switching node, and an output connected to the output connection of said respective switching node wherein said control input is at a steady-state logic level for permanently enabling said second logic gate; and
means for establishing a desired switching path between a selected one of said input ports (1 to 8) receiving said selected input signal and said output port by applying an appropriate combination of control signals to the control input of said first stage logic gates (10);
whereby only that first stage logic gate and those switching nodes in said chosen path are operable to undergo switching, thereby allowing only said selected input signal to propagate through said plurality of cascaded stages.

4. The switch matrix as recited in claim 3 wherein: each first stage logic gate being a NAND gate; and each of said first and second logic gates being a NAND gate.

5. The switch matrix as recited in claim 4 further including:
control input signal means for providing control signals on the control inputs of said first stage logic gates (10).

6. The switch matrix as recited in claims 3 or 4 wherein:
said steady-state logic level being a HIGH state logic level.

7. The switch matrix as recited in claim 5 wherein said control input signal means further includes:
a shift register.

## Patentansprüche

1. Schaltmatrix zum Empfang von digitalen Eingangssignalen an Eingangskanälen (1-8) und zur Ausgabe eines ausgewählten dieser Signale als ein Ausgangssignal, umfassend:
eine erste Auswahlstufe mit einer Vielzahl von logischen Gattern (100), von denen jedes einen Dateneingang, der mit einem entsprechenden der Eingangskanäle verbunden ist, einen Steuereingang und eine Ausgangsleitung aufweist;
eine zweite Auswahlstufe, die in Kaskade zu der ersten Auswahlstufe angeordnet ist und eine gleiche Vielzahl von logischen Gattern (200) umfaßt, von denen jedes einen Dateneingang, der mit einer Ausgangsleitung (14) eines logischen Gatters der ersten Auswahlstufe verbunden ist, einen Steuereingang und eine Ausgangsleitung aufweist;
eine Vielzahl von kaskadierten Stufen, die logische Gatter (200, 300, 400) aufweisen, die einer Multiplex-Konfiguration angeordnet sind, um logische Signale zu empfangen und das ausgewählte Signal bereitzustellen;
wobei jedes logische Gatter (300, 400, 500) in der Vielzahl von kaskadierten Stufen eine Ausgangsleitung aufweist, sowie einen ersten Eingang, der mit einem Ausgang der logischen Gatter der vorangehenden Stufe verbunden ist und einen zweiten Eingang, der mit einem anderen Ausgang der logischen Gatter der vorangehenden Stufe verbunden ist;
eine Einrichtung zum Errichten eines gewünschten Schaltpfades in der Vielzahl von kaskadierten Stufen durch Anlegen einer geeigneten Kombination von digitalen Signalen an die Steuereingänge der logischen Gatter (100, 200) in der ersten und zweiten Auswahlstufe,
wobei nur die logischen Gatter in dem gewählten Pfad betreibbar sind, um einen Schaltvorgang durchzuführen, wodurch sich nur das ausgewählte Eingangssignal durch die Schaltmatrix ausbreiten kann.

2. Matrix nach Anspruch 1, worin die logischen Gatter (100, 200) in der ersten und zweiten Auswahlstufe NAND-Gatter sind und die logischen Gatter (300, 400, 500) in der Multiplex-Konfiguration NAND-Gatter sind.

3. Schaltmatrix zum Empfang von digitalen Eingangssignalen an Eingangskanälen (1-8) und zum Bereitstellen eines ausgewählten der Signale über einen Ausgangskanal, umfassend:
eine Vielzahl von kaskadierten Stufen, worin die erste Stufe eine Vielzahl von logischen Gattern (10) und die übrigen Stufen eine Vielzahl von Vermittlungsknoten (N20, N30, N40) umfassen, von denen jeder einen ersten Eingangsanschluß, einen zweiten Eingangsanschluß, einen Ausgangsanschluß und einen Steuereingangsanschluß aufweist und worin jeder Ausgangsanschluß einen einzelne Eingangsanschluß in einer folgenden Stufe betätigt;
wobei jedes der logischen Gatter (10) einen Dateneingang, der mit einem entsprechenden der Eingangskanäle (1-8) verbunden ist, einen Steuereingang und eine Ausgangsleitung aufweist, worin jede Ausgangsleitung den Eingangsanschluß eines einzelnen Vermittlungsknotens in einer nächsten Stufe betätigt;
der Ausgangskanal mit dem Ausgangsanschluß eines einzelnen Vermittlungsknotens (N40) in der letzten Stufe gekoppelt ist;
jeder der Vermittlungsknoten (N20, N30, N40) ein erstes logisches Gatter (20, 30, 40) umfaßt mit einem ersten Dateneingang, der mit dem ersten Eingangsanschluß des entsprechenden Vermittlungsknotens verbunden ist, einem zweiten Dateneingang, der mit dem zweiten Eingangsanschluß des entsprechenden Vermittlungsknotens verbunden ist und mit einem Ausgang;
jeder der Vermittlungsknoten weiterhin ein zweites logisches Gatter (25) aufweist, welches kaskadiert zu dem zugehörigen ersten logischen Gatter (20) angeordnet ist und einen Dateneingang, der mit dem Ausgang des zugehörigen ersten logischen Gatters verbunden ist, einen Steuereingang (24), der mit dem Steuereingangsanschluß des entsprechenden Vermittlungsknotens verbunden ist und einen Ausgang aufweist, der mit dem Ausgangsanschluß des entsprechenden Vermittlungsknotens verbunden ist, wobei der Steuereingang sich im eingeschwungenen Zustand auf einem logischen Pegel zur ständigen Freigabe des zweiten logischen Gatters befindet; und
eine Einrichtung vorgesehen ist zum Aufbau eines gewünschten Schaltpfades zwischen einem der ausgewählten Eingangskanäle (1-8), welche das ausgewählte Eingangssignal empfangen und dem Ausgangskanal durch Anlegen einer geeigneten Kombination von Steuersignalen an den Steuereingang der logischen Gatter (10) der ersten Stufe;
wobei nur dasjenige logische Gatter der ersten Stufe und solche Vermittlungsknoten in dem gewählten Pfad bedienbar sind, um eine Vermittlung durchzuführen, wodurch sich nur das ausgewählte Eingangssignal durch die Vielzahl der kaskadierten Stufen ausbreiten kann.

4. Die Schaltmatrix nach Anspruch 3, worin jedes der logischen Gatter der ersten Stufe ein NAND-Gatter ist und jedes der ersten und zweiten logischen Gatter ein NAND-Gate ist.

5. Schaltmatrix nach Anspruch 4, weiterhin umfassend eine steuereingangssignaleinrichtung zum Bereitstellen von Steuersignalen an den Steuereingängen der logischen Gatter (10) der ersten Stufe.

6. Schaltmatrix nach Anspruch 3 oder 4, worin der logische Pegel im eingeschwungenen Zustand vom Typ "HIGH" ist.

7. Schaltmatrix nach Anspruch 5, worin die Steuereingangssignaleinrichtung weiterhin ein Schieberegister umfaßt.

## Revendications

1. Matrice de commutation recevant des signaux d'entrée numériques par des portes d'entrée (1 à 8) et délivrant un sélectionné des dits signaux en tant que signal de sortie, comprenant :
un premier étage de sélection incluant une pluralité de portes logiques (100) ayant chacune une entrée de données connectée à une correspondante des dites portes d'entrée, une entrée de commande et une ligne de sortie ;
un deuxième étage de sélection en cascade avec le dit premier étage de sélection, incluant une pluralité semblable de portes logiques (200) ayant chacune une entrée de données connectée à une ligne unique (14) de sortie des portes logiques à partir du dit premier étage de sélection, une entrée de commande et une ligne de sortie ;
une pluralité d'étages en cascade comprenant des portes logiques (200, 300, 400) disposées en une configuration de multiplexage pour recevoir les signaux logiques et délivrant le dit signal choisi ;
chaque porte logique (300, 400, 500) de la dite pluralité d'étages en cascade ayant une ligne de sortie, une première entrée connectée à une des dites sorties des portes logiques d'un étage précédent, et une deuxième ligne d'entrée connectée à une différente des dites sorties des portes logiques du dit étage précédent ;
un moyen pour établir un chemin souhaité de commutation dans la dite pluralité d'étages en cascade en appliquant une combinaison appropriée de signaux numériques aux entrées de commande des dites portes logiques (100, 200) des dits premier et deuxième étages de sélection ;
de telle manière que seules les dites portes logiques dans le dit chemin choisi sont susceptibles de subir une commutation, permettant seulement au dit signal d'entrée sélectionné de se propager à travers la dite matrice de commutation.

2. Matrice de commutation selon la revendication 1 dans laquelle :
les dites portes logiques (100, 200) dans les dits premier et deuxième étages de sélection sont des portes NON-ET ; et
les dites portes logiques (300, 400, 500) dans la dite configuration de multiplexage sont des portes NON-ET.

3. Matrice de commutation recevant des signaux d'entrée numériques par des portes d'entrée (1 à 8) et délivrant un sélectionné des dits signaux à une porte de sortie, comprenant :
une pluralité d'étages en cascade dans laquelle le dit premier étage comprend une pluralité de portes logiques (10) et dans laquelle les dits autres étages comprennent une pluralité de noeuds de commutation (N20, N30, N40) ayant chacun une première connexion d'entrée, une deuxième connexion d'entrée, une connexion de sortie et une connexion d'entrée de commande, chaque connexion de sortie commandant une unique connexion d'entrée dans un étage suivant ;
chacune des dites portes logiques (10) ayant une entrée de données connectée à une correspondante des dites portes d'entrée (1 à 8), une entrée de commande et une ligne de sortie, chaque ligne de sortie commandant la connexion d'entrée d'un unique noeud de commutation dans un étage suivant ;
les dites portes de sortie étant couplées à la connexion de sortie d'un unique noeud de commutation (N40) dans le dit dernier étage ;
chacun des dits noeuds de commutation (N20, N30, N40) incluant une première porte logique (20, 30, 40) ayant une première entrée de données connectée à la première connexion d'entrée du dit noeud respectif de commutation, une deuxième entrée de données connectée à la deuxième connexion d'entrée du dit noeud respectif de commutation, et une sortie ;
chacun des dits noeuds de commutation incluant, en outre, une deuxième porte logique (25) en cascade avec la dite première porte logique associée (20) et ayant une entrée de données connectée à la sortie de la dite première porte logique associée, une entrée de commande (24) connectée à la connexion d'entrée de commande du dit noeud respectif de commutation, et une sortie connectée à la connexion de sortie du dit noeud respectif de commutation, la dite entrée de commande étant à un niveau logique en état stable pour valider de façon permanente la dite deuxième porte logique ; et
un moyen d'établissement d'un chemin de commutation souhaité entre une sélectionnée des dites portes d'entrée (1 à 8) recevant le dit signal d'entrée sélectionné, et la dite porte de sortie en appliquant une combinaison appropriée de signaux de commande à l'entrée de commande des dites portes logiques (10) du premier étage;
de telle manière que la porte logique du premier étage et celles des noeuds de commutation dans le dit chemin choisi fonctionnent pour subir la commutation, permettant ainsi seulement au dit signal d'entrée sélectionné de se propager à travers la dite pluralité d'étages en cascade.

4. Matrice de commutation selon la revendication 3 dans laquelle chaque porte logique du premier étage est une porte NON-ET et chacune des dites premières et deuxièmes portes logiques sont des portes NON-ET.

5. Matrice de commutation selon la revendication 4 incluant, en outre, un moyen de signaux d'entrée de commande pour appliquer des signaux de commande aux entrées de commande des dites portes logiques (10) du premier étage.

6. Matrice de commutation selon la revendication 3 ou 4 dans laquelle le dit niveau logique en état stable est un niveau logique à l'état HAUT.

7. Matrice de commutation selon la revendication 5 dans laquelle le dit moyen de signaux d'entrée de commande inclut, en outre, un registre à décalage.
